# EUROPÄISCHE PATENTSCHRIFT

(11) **EP 2 417 619 B1**
(45) Veröffentlichungstag und Bekanntmachung des Hinweises auf die Patenterteilung: **16.11.2016**
(21) Anmeldenummer: 10717569.7
(22) Anmeldetag: 31.03.2010
(51) Int. Cl.: H01J 37/32

(54) **PROZESSKAMMER MIT MODULIERTER PLASMAVERSORGUNG**
PROCESS CHAMBER HAVING MODULATED PLASMA SUPPLY
CHAMBRE DE TRAITEMENT À ALIMENTATION EN PLASMA MODULÉE

(30) Priorität: 06.04.2009 DE 102009016701
(43) Veröffentlichungstag der Anmeldung: 15.02.2012
(73) Patentinhaber: Forschungsverbund Berlin e.V., 12489 Berlin (DE)
(72) Erfinder: GESCHE, Roland, 63500 Seligenstadt (DE)
(74) Vertreter: Gulde & Partner
(86) Internationale Anmeldenummer: PCT/EP2010/054340
(87) Internationale Veröffentlichungsnummer: WO 2010/115816

(56) Entgegenhaltungen:
- WO-A1-99/07913
- WO-A1-99/14699
- WO-A2-02/29849
- US-A1- 2002 096 257
- US-A1- 2003 151 372
- US-B1- 6 193 855

## Beschreibung

### Hintergrund der Erfindung

Plasmaprozesse mit Hochfrequenzanregung finden vielfältige Anwendungen, insbesondere in der Oberflächentechnik. Hierzu gehört das Beschichten von Oberflächen durch Sputtern oder PECVD, das Ätzen mittels physikalischer (Sputterätzen), chemischer (Plasmaätzen) oder gemischter Wirkung (Reactive Ion Etching, RIE), sowie die Aktivierung, Reinigung und Modifikation von Oberflächen.

Wichtige Prozessparameter sind hierbei die Plasmadichte und die kinetische Energie der im Plasma erzeugten Teilchen, insbesondere die mittlere Geschwindigkeit der Ionen.

Die Plasmadichte ist mit der Leistungsdichte verknüpft und bildet ein Maß für die Gesamtwirksamkeit, mit der zum Beispiel der Ionenstrom zusammenhängt.

Die kinetische Energie der Ionen (Ionenenergie) ist physikalisch direkt mit der mittleren Geschwindigkeit der Ionen verbunden und entsteht bei Hochfrequenzanregung durch das sogenannte "Self-Bias Potential". Das Self-Bias Potential wirkt als Beschleunigungsspannung auf die freien Ladungsträger im Plasma und ist damit ein wesentlicher Prozessparameter, dessen Kontrolle angestrebt wird, um reproduzierbare Prozessbedingungen zu schaffen. Das Self-Bias Potential ist eine Gleichspannung und wird durch den Gleichrichteffekt des Plasmas erzeugt. Dieser Effekt tritt in einem Frequenzbereich von kHz bis ca. 100 MHz auf und geht auf die unterschiedliche Beweglichkeit der Ionen und freien Elektronen im Plasma zurück. Die freien Elektronen besitzen aufgrund ihres geringen Gewichtes eine besonders hohe Beweglichkeit und diffundieren daher vom Ort ihrer Entstehung (hohe Konzentration) schneller weg als die elektrisch entgegengesetzt geladenen Ionen. Es bilden sich auf diese Weise Raumladungszonen, deren elektrische Kraftwirkung der Diffusion der Elektronen entgegenwirkt. Die zwischen den Raumladungszonen wirkende Spannung ist das obengenannte Self-Bias Potential und stellt beim Sputtern, Sputterätzen und beim RIE die effektive Beschleunigungsspannung für die Ionen dar. Daher ist es je nach prozesstechnischer Anwendung erstrebenswert, das Self-Bias Potential einstellen zu können. Hierzu gibt es verschiedene bekannte Verfahren, die jedoch alle den Nachteil eine wechselseitigen Abhängigkeit von Plasmadichte und kinetischer Energie der Ionen besitzen:

### Druck

Das Self-Bias Potential ist u.a. vom in der Plasmakammer herrschenden Druck und damit der Plasmadichte abhängig. Bei höheren Drücken sinkt das Self-Bias Potential wegen der steigenden Plasmadichte und der damit abnehmenden Diffusionsweite. Hierbei gibt es allerdings nur ein begrenztes Prozessfenster, höhere Drücke führen zu Instabilitäten und Inhomogenitäten.

### Magnetischer Plasmaeinschluss

Bei Sputter-Beschichtungsprozessen finden Magnetronkathoden weite Verwendung. Durch magnetischen Einschluss wird die Plasmadichte erhöht und das Self-Bias Potential verringert, was eine höhere Beschichtungsrate zur Folge hat. Nachteilig ist hierbei, dass das Target sehr ungleichmäßig abgetragen und dadurch die Beschichtung inhomogen wird, was gewöhnlich durch Bewegung der zu beschichtenden Substrate kompensiert werden soll. Magnetische Plasmaeinschlüsse haben sich bei Ätz-und PECVD-Prozessen nicht durchgesetzt, weil die erwähnte Inhomogenität bei den hier üblichen statischen Verfahren nur schlecht kompensiert werden kann.

### Verfahren mit zwei Elektroden

In verschiedenen Plasmaverfahren wird das Plasma mit einer ersten Elektrode erzeugt und mit einer zweiten, unter dem Substrat platzierten Elektrode extrahiert. Die Beschleunigungsspannung kann dabei in gewissem Rahmen unabhängig von der Plasmaerzeugung über die Substratelektrode vorgegeben werden. Nachteilig bei allen Verfahren dieser Kategorie ist, dass zwei Versorgungen mit Anpassungsnetzwerken, Vakuumdurchführungen und Elektroden bzw. Antennen benötigt werden, was aufwendig ist und in manchen Fällen (z.B. Substratbias bei bewegten Substraten) schwer oder gar nicht realisierbar.

Ein System und Verfahren zur Überwachung und Kontrolle eines Gasplasmaprozesses ist aus zum Beispiel WO 99/14699 bekannt, welches ein plasmakoppelndes Element umfasst, welches eine Spule, einen elektrostatischen Chuck und ein Bias-Schild umfasst, wobei Hochfrequenzleistung zum plasmakoppelnden Element durch entsprechende Phase/Amplituden Detektoren geschickt wird.

Es besteht daher Bedarf an einer Vorrichtung, die eine möglichst unabhängige Einstellung von Plasmadichte und Ionenenergie erlaubt. Daher ist Aufgabe der Erfindung, eine Plasmakammer einzuführen, die ein Einstellen des Self-Bias Potentials (bzw. der Self-Bias Spannung) und.somit möglichst reproduzierbare Bedingungen im Plasma ermöglicht.

### Zusammenfassung der Erfindung

Die Erfindung löst die Aufgabe durch eine Plasmakammer mit einer an einer ersten Seite befestigten ersten Aufnahmevorrichtung für ein Substrat und mit einer Plasmaerzeugungseinheit zum Erzeugen eines Plasmas in der Plasmakammer ein. Die Plasmaerzeugungseinheit enthält zur Erzeugung des Plasmas beispielsweise ein Sputter-Target, eine Elektrode oder eine Antenne und ist mit einer Hochfrequenzspannungsversorgung verbunden oder verbindbar, welche erfindungsgemäß ausgebildet ist, eine modulierte hochfrequente Wechselspannung zu erzeugen und an die Plasmaerzeugungseinheit auszugeben, wobei die Plasmaerzeugungseinheit ist ausgebildet, das Plasma mit der modulierten hochfrequenten Wechselspannung zu erzeugen, und wobei die Plasmakammer eine Messeinrichtung aufweist, welche ausgebildet ist, ein Self-Bias Potential des Plasmas in der Plasmakammer zu bestimmen und als Messwert auszugeben, wobei die Plasmaerzeugungseinheit eine induktive Antenne ist und wobei ein Target so floatend in der Plasmakammer angeordnet ist, dass eine Self-Bias-Spannung am Target durch Frequenzumsetzen der von der Hochfrequenzspannungserzeugung erzeugten hochfrequenten modulierten Wechselspannung im Plasma erzeugt wird.

Grundidee der Erfindung ist, die Nichtlinearität des Plasmas als elektrischen Mischer zu verwenden und so das Plasma zu einem elektrischen Bauteil der Versorgung zu machen. Indem das Plasma mit einem modulierten Signal versorgt wird, entstehen im Plasma Mischprodukte, von denen insbesondere die Differenzfrequenzen vorteilhaft im Prozess genutzt werden können. So kann eine durch dergestalt im Plasma aus der modulierten hochfrequenten Wechselspannung demodulierte Komponente der modulierten hochfrequenten Wechselspannung zum Einstellen des Self-Bias Potentials vorteilhaft verwendet werden. Dieses Einstellen kann ein Erzeugen eines Self-Bias Potentials durch die modulierte hochfrequente Wechselspannung oder aber ein geeignetes Verändern eines vorhandenen beziehungsweise sich von selbst einstellenden Self-Bias Potentials auf einen gewünschten Wert umfassen. Es sind dabei diverse Modulationsarten vorstellbar, wie z.B. die Amplitudenmodulation, Phasenmodulation, Frequenzmodulation oder Quadraturmodulationen. Ebenso können Zweiton- und Mehrton-Signale zur Anwendung kommen.

Durch Verwendung einer Messeinrichtung, welche ausgebildet ist, ein Self-Bias Potential des Plasmas in der Plasmakammer zu bestimmen und als Messwert auszugeben, kann das tatsächlich im Plasma anliegende Self-Bias Potential bestimmt werden, um gegebenenfalls die Parameter für den Plasmaprozess anpassen zu können.

Unter "hochfrequent" ist im Rahmen der Erfindung eine Frequenz zu verstehen, die hoch genug ist, als Trägerfrequenz für ein Signal zu dienen, das in der Läge ist, das erwähnte Self-Bias Potential zu erzeugen. Das aufmodulierte Signal besitzt damit bevorzugt eine Frequenz jm Bereich von ca. 1 kHz bis ca. 100 MHz. Die Trägerfrequenz kann am oberen Ende dieses Frequenzbereichs oder darüber liegen, bevorzugt oberhalb von 70 MHz. Es ist jedoch auch möglich, mit einer Trägerfrequenz im kHz- oder MHz-Bereich zu arbeiten und als Differenzfrequenz eine niedrigere Frequenz zu wählen, die jedoch auch mindestens im kHz-Bereich liegen sollte.

Die Plasmakammer kann eine Benutzerschnittstelle für die Eingabe eines Sollspannungswertes aufweisen. Die Hochfrequenzspannungsversorgung ist dabei ausgebildet, die modulierte hochfrequente Wechselspannung mit einer durch den Sollspannungswert vorgegebenen Amplitude eines aufmodulierten Signales zu erzeugen.

Bei dieser Ausführungsform kann durch Vorgabe eines gewünschten Sollspannungswertes direkt auf die von der Hochfrequenzspannungsversorgung erzeugte modulierte hochfrequente Wechselspannung und damit auf das Self-Bias Potential Einfluss genommen werden. Selbstredend können auch andere Parameter durch die Benutzerschnittstelle einstellbar sein wie z.B. abhängig von der verwendeten Modulationsart Frequenzen von Trägerfrequenz oder aufmoduliertem Signal.

Die Plasmakammer kann neben der Benutzerschnittstelle und der Messeinrichtung über eine kontrolleinheit verfügen, welche mit der Benutzerschnittstelle, der Hochfrequenzspannungsversorgung und der Messeinrichtung verbunden und ausgebildet ist, den Messwert der Messeinrichtung und den Sollspannungswert zu vergleichen und die Hochfrequenzspannungsversorgung gemäß einem Ergebnis des Vergleiches zu regeln, wenn der Messwert der Messeinrichtung von dem durch die Benutzerschnittstelle eingegebenen Spannungswert abweicht. Auf diese Weise entsteht ein Regelsystem, das nach bekannter Art das Self-Bias Potential überwachen und auf den gewünschten Sollspannungswert regeln kann.

Die modulierte hochfrequente Wechselspannung kann eine Mittenfrequenz und eine Bandbreite aufweisen, wobei die Mittenfrequenz bevorzugt zwischen 50 kHz und 10 GHz beträgt. Bevorzugt ist die Bandbreite kleiner als Mittenfrequenz, besonders bevorzugt kleiner als die halbe Mittenfrequenz.

Bei einer Ausführungsform der Erfindung weist die modulierte hochfrequente Wechselspannung wenigstens einen ersten Ton einer ersten Frequenz und einen zweiten Ton einer zweiten Frequenz auf. Die zweite Frequenz unterscheidet sich um eine Differenzfrequenz von der ersten Frequenz. Bei dieser Ausführungsform entsteht durch die Nichtlinearität einer im Betrieb in der Plasmakammer befindlichen Gasentladung eine Wechselspannung im Plasma mit der Frequenz der Differenzfrequenz. Diese Wechselspannung wirkt als Beschleunigungsspannung für die Ionen im Plasma und kann hinsichtlich Betrag und Frequenz unabhängig von der Plasmaerzeugung eingestellt werden. Besonders bevorzugt beträgt die Differenzfrequenz wenigstens 25 kHz und höchstens 100 MHz.

Die modulierte hochfrequente Wechselspannung kann auch ein Multitonsignal sein, also eine Mehrzahl von Tönen aufweisen. Hierbei ist es vorstellbar, dass die Töne äquidistant angeordnet sind, um die aufgrund der Nichtlinearität des Plasmas über diesem anliegende Wechselspannung mit der Frequenz der Differenzfrequenz zu verstärken. Ebenso ist es vorstellbar, mehrere verschiedene Differenzsignale zu erzeugen, welche sich z.B. zu einer gewünschten periodischen Wellenform der Wechselspannung über dem Plasma summarisch überlagern können.

Alternativkann die modulierte hochfrequente Wechselspannung ein amplitudenmoduliertes oder ein digitalmoduliertes Signal sein. Wiederum alternativ kann die modulierte hochfrequente Wechselspannung ein phasen- oder frequenzmoduliertes Signal sein.

Alle Ausführungsformen der Erfindung können an einer zweiten Seite eine zweite Aufnahmevorrichtung für ein Target besitzen.

### Kurzbeschreibung der Abbildungen

Die Erfindung wird im Folgenden anhand einiger Abbildungen von Ausführungsbeispielen näher erläutert. Es zeigen:
- Fig. 1: eine Plasmakammer mit Sputterkathode mit direkter Versorgung;
- Fig. 2: eine als Induktive Coupled Plasma (ICP) Ätzanlage realisierte Plasmakammer; und
- Fig. 3: eine Plasmakammer für das Sputtern über eine induktive Kopplung.

### Ausführliche Beschreibung der Abbildungen

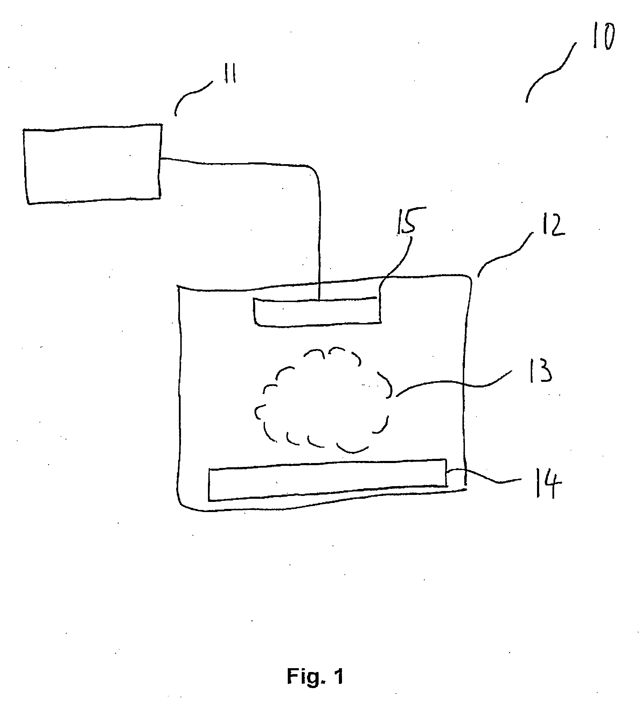

Fig. 1 zeigt eine Plasmakammer 10 mit Sputterkathode (Target) 15 mit direkter Versorgung. Die Plasmakammer 10 umfasst eine Vakuumkammer 12, in der auf einer ersten Seite das Substrat 14 und auf einer (gegenüberliegenden) zweiten Seite das Target 15 angeordnet sind. In der Vakuumkammer 12 wird eine für die Kathodenzerstäubung (Sputtern) geeignete Prozessgasumgebung hergestellt und ein Plasma 13 erzeugt, das durch Stoßreaktionen Material aus dem Target 15 löst, welches sich dann auf dem Substrat 14 niederschlagen kann. Das Target 15 ist direkt mit einer Hochfrequenzspannungsversorgung 11 verbunden, so dass die von der Hochfrequenzspannungsversorgung 11 erzeugte hochfrequente modulierte Wechselspannung direkt am Target 15 anliegt und das Target 15 wie beschrieben als Sputterkathode wirkt. Erfindungsgemäß wird eine Trägerfrequenz gewählt, die am oberen Ende des Self-Bias Spannungsbereichs oder darüber liegt. Durch das Frequenzumsetzen im elektrisch nichtlinearen Plasma 13 entstehen in diesem niederfrequente Mischprodukte, durch die eine geeignete Self-Bias-Spannung erzeugt wird und über die hochfrequente modulierte Wechselspannung im wesentlichen unabhängig von der Plasmadichte eingestellt werden kann. Dadurch kann der Ionenstrom (abhängig von der Plasmadichte) unabhängig von der Ionenenergie (abhängig von der Self-Bias-Spannung) eingestellt werden. Zusätzlich können - wie bekannt - Magnetfelder zum Plasmaeinschluss verwendet werden.

Die *Erfindung* besitzt den weiteren Vorteil, dass ein Substratbias gebildet wird, was für eine Vielzahl von Beschichtungsprozessen nützlich ist. Nach dem Stand der Technik wird das Substratbias durch eine zweite Spannungsversorgung realisiert, welche dem Substrat 14 ebenfalls elektrische Energie zuführt. Hierzu ist jedoch eine zweite Spannungsversorgung mit Anpassungsnetzwerk, Vakuumdurchführung und Substratelektrode notwendig. Letztere kann sehr aufwendig oder gar nicht realisierbar sein, z.B. bei bewegten Substraten 14. Erfindungsgemäß kann das Substratbias nun durch die hochfrequente modulierte Wechselspannung erzeugt. Hierzu muss das Substrat 14 lediglich floatend, also elektrisch isoliert, angeordnet werden. Bei hinreichend isolierenden Substratmaterialien kann auch schon die Eigenisolation des Substrates 14 genügen. Die Oberfläche des Substrates 14 wird nun aufgeladen, da die Ladungsträger nicht abfließen können. Das Frequenzumsetzen der hochfrequenten modulierten Wechselspannung führt zur Bildung einer Self-Bias-Spannung auch am Substrat 14.

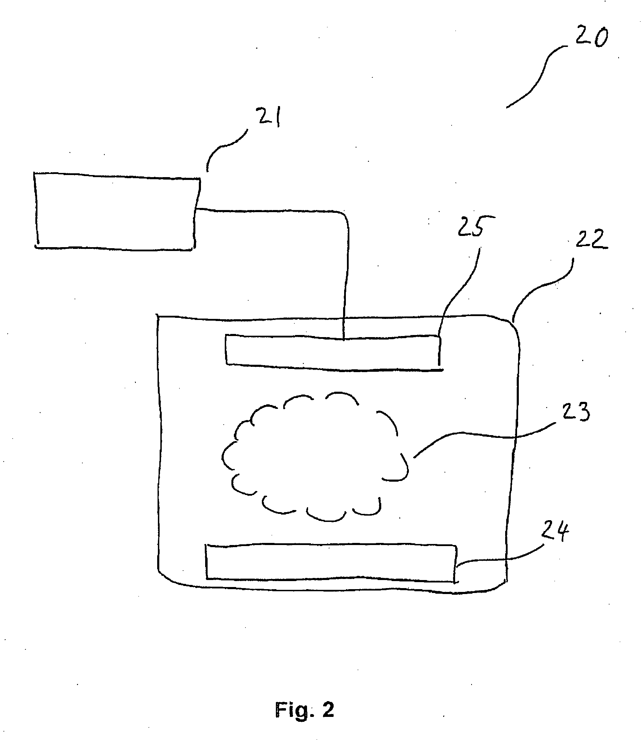

Die Kontrolle der Self-Bias-Spannungen an Target 15 und Substrat 14 kann erfindungsgemäß auch kombiniert werden. Hierzu wird ein Mehrtonsignal verwendet, welches verschiedene Differenzfrequenzen enthält. Hierdurch entstehen Self-Bias-Spannungen am Target 15 und Substrat 14, die über die Variation der Modulation eingestellt werden können. Als Möglichkeiten der Variation der Modulation ist vorstellbar, die relative Lage von Tönen im Spektrum zu verändern oder deren Betrag und Phase anzupassen. Fig. 2 zeigt eine als Inductive Coupled Plasma (ICP) Ätzanlage realisierte Plasmakammer 20. Im wesentlichen gleichen sich die Funktionsweisen dieses Ausführungsbeispiels und des Beispiels von Fig. 1. In einer Vakuumkammer 22 wird wiederum ein Plasma 23 erzeugt, um ein in der Vakuumkammer 22 befindliches Substrat 24 zu bearbeiten. Eine Hochfrequenzspannungserzeugung 21 ist hier jedoch mit einer ICP-Antenne 25 verbunden, welche induktiv wirkt und so das Plasma 23 erzeugt. Im Stand der Technik wird beim ICP-Ätzen eine Hochfrequenzspannungsversorgung für das Substrat 24 vorgesehen. Dieser zusätzliche Aufwand wird durch die Erfindung überflüssig, weil das Substratbias wie bereits beschrieben durch die Demodulation der IGP-Versorgungsspannung im Plasma 23 erzeugt werden kann.

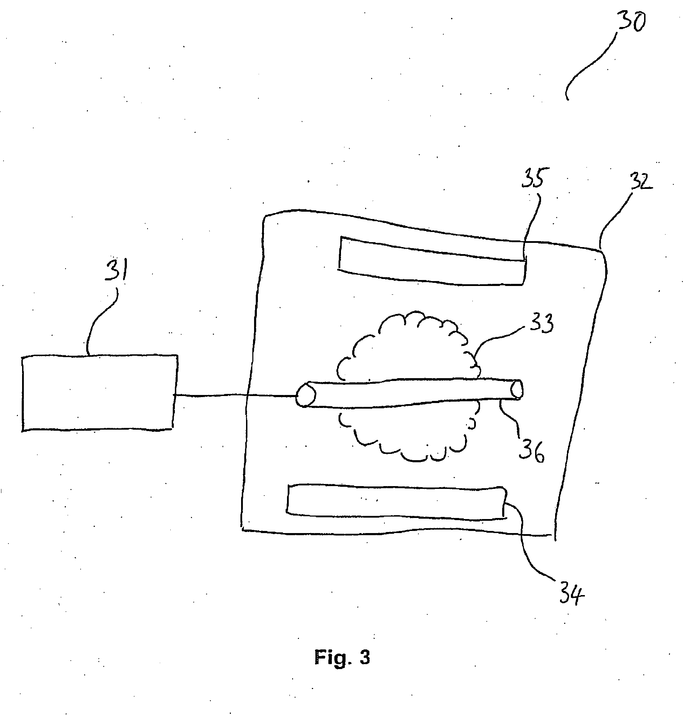

Fig. 3 zeigt eine Plasmakammer 30 für das Sputtern über eine induktive Kopplung. Wiederum ist die Funktionsweise des gezeigten Ausführungsbeispiels der der vorhergehenden Ausführungsbeispiele sehr ähnlich. Eine Hochfrequenzspannungs-erzeugung 31 versorgt eine induktive Antenne 36 mit einer hochfrequenten modulierten Wechselspannung und erzeugt so ein Plasma 33 in einer Vakuumkammer 32. Ein Target 35 ist floatend in der Vakuumkammer 32 angeordnet. Ein Substrat 34 kann ebenfalls floatend in der Vakuumkammer 32 angeordnet werden, es ist aber auch vorstellbar, das Substrat 34 über eine gesonderte Spannungsversorgung auf ein gewünschtes Potential zu legen. Die Self-Bias-Spannung am Target 35 wird wiederum durch Frequenzumsetzen der von der Hochfreqüenzspannungserzeugung 31 erzeugten hochfrequenten modulierten Wechselspannung im Plasma 33 erzeugt. Durch weitere Differenzfrequenzen kann auch ein Self-Bias am Substrat 34 realisiert werden. In diesem Fall muss das Substrat 34 floatend angeordnet sein.

Die beschriebenen Beispiele können sinngemäß auch mit Trägerfrequenzen im Mikrowellenbereich realisiert werden, wobei dann z.B. Hohlleiterantennen zur Einstrahlung der elektrischen Energie Verwendung finden können. Ebenso ist es auch vorstellbar, dass Arrays solcher Antennen verwendet werden.

## Patentansprüche

1. Eine Plasmakammer (10, 20, 30) mit einer an einer ersten Seite einer Vakuumkammer (12, 22, 32) befestigten ersten Aufnahmevorrichtung für ein Substrat (14, 24, 34) und mit einer Plasmaerzeugungseinheit für das Erzeugen eines Plasmas in der Plasmakammer (10, 20, 30), wobei die Plasmaerzeugungseinheit mit einer Hochfrequenzspannungsversorgung (11,21,31) verbunden oder verbindbar ist, wobei die Hochfrequenzspannungsversorgung (11,21,31) ausgebildet ist, eine modulierte hochfrequente Wechselspannung zu erzeugen und an die Plasmaerzeugungseinheit auszugeben, und wobei die Plasmaerzeugungseinheit ausgebildet ist, das Plasma mit der modulierten hochfrequenten Wechselspannung zu erzeugen,
**dadurch gekennzeichnet, dass**
die Plasmakammer eine Messeinrichtung aufweist, die ausgebildet ist, ein Self-Bias Potential des Plasmas in der Plasmakammer zu bestimmen und als Messwert auszugeben, wobei die Plasmaerzeugungseinheit eine induktive Antenne (36) ist und wobei ein Target so floatend in der Plasmakammer (10, 20, 30) angeordnet ist, dass eine Self-Bias-Spannung am Target (35) durch Frequenzumsetzen der von der Hochfrequenzspannungserzeugung (31) erzeugten hochfrequenten modulierten Wechselspannung im Plasma (33) erzeugt wird.

2. Die Plasmakammer (10, 20, 30) von Anspruch 1, mit einer Benutzerschnittstelle für die Eingabe eines Sollspannungswertes, wobei die Hochfrequenzspannungsversorgung (11, 21, 31) ausgebildet ist, die modulierte hochfrequente Wechselspannung mit einer durch den Sollspannungswert vorgegebenen Amplitude eines aufmodulierten Signales zu erzeugen.

3. Die Plasmakammer (10, 20, 30) von Anspruch 1 und 2, mit einer Kontrolleinheit, welche mit der Benutzerschnittstelle, der Hochfrequenzspannungsversorgung (11,21,31) und der Messeinrichtung verbunden und ausgebildet ist, den Messwert der Messeinrichtung und den Sollspannungswert zu vergleichen und die Hochfrequenzspannungsversorgung (11, 21, 31) gemäß einem Ergebnis des Vergleiches zu regeln, wenn der Messwert der Messeinrichtung von dem durch die Benutzerschnittstelle eingegebenen Spannungswert abweicht.

4. Die Plasmakammer (10, 20, 30) von einem der vorhergehenden Ansprüche, bei der die modulierte hochfrequente Wechselspannung eine Mittenfrequenz und eine Bandbreite aufweist,
wobei die Mittenfrequenz vorzugsweise zwischen 50 kHz und 10 GHz beträgt,
wobei die Bandbreite vorzugsweise kleiner als Mittenfrequenz ist
und wobei die Bandbreite vorzugsweise kleiner als die halbe Mittenfrequenz ist.

5. Die Plasmakammer (10, 20, 30) von einem der vorhergehenden Ansprüche, bei der die modulierte hochfrequente Wechselspannung wenigstens einen ersten Ton einer ersten Frequenz und einen zweiten Ton einer zweiten Frequenz, welche sich um eine Differenzfrequenz, wobei die Differenzfrequenz vorzugsweise wenigstens 25 kHz und vorzugsweise höchstens 100 MHz beträgt, von der ersten Frequenz unterscheidet, aufweist.

6. Die Plasmakammer (10, 20, 30) von einem der vorhergehenden Ansprüche, bei der die modulierte hochfrequente Wechselspannung ein Multitonsignal ist.

7. Die Plasmakammer (10, 20, 30) von einem der Ansprüche 1 bis 5, bei der die modulierte hochfrequente Wechselspannung ein amplitudenmoduliertes oder ein digitalmoduliertes Signal ist.

8. Die Plasmakammer (10, 20, 30) von einem der Ansprüche 1 bis 5, bei der die modulierte hochfrequente Wechselspannung ein phasen- oder frequenzmoduliertes Signal ist.

9. Die Plasmakammer (10, 20, 30) von einem der vorhergehenden Ansprüche, bei der an einer zweiten Seite der Vakuumkammer (12, 22, 32) eine zweite Aufnahmevorrichtung für ein Target (15, 25, 35) angeordnet ist.

10. Die Plasmakammer (10, 20, 30) von einem der vorhergehenden Ansprüche, wobei das Substrat (34) floatend ist, so dass durch weitere Differenzfrequenzen ein Self-Bias am Substrat realisiert werden kann.

11. Die Plasmakammer (10, 20, 30) von einem der vorhergehenden Ansprüche, Die Plasmakammer (10, 20, 30) von einem der vorhergehenden Ansprüche, wobei die induktive Antenne eine Hohlleiterantenne ist.

## Claims

1. A plasma chamber (10, 20, 30) including a first holding device for a substrate (14, 24, 34), which holding device is attached to a first side of a vacuum chamber (12, 22, 32), and including a plasma generation unit for generating a plasma in the plasma chamber (10, 20, 30), which plasma generation unit is connected to a high-frequency voltage supply (11, 21, 31), wherein the high-frequency voltage supply (11, 21, 31) is designed to generate a modulated high-frequency alternating voltage and to output said voltage to the plasma generation unit, and wherein the plasma generation unit is designed to generate the plasma using the modulated high-frequency alternating voltage, the plasma generation unit being an inductive antenna (36),
**characterized in that**
the plasma chamber includes a measuring device which is designed to determine a self-bias potential of the plasma contained in the plasma chamber and to output said potential as a measured value, wherein a target is arranged so as to float in the plasma chamber (10, 20, 30).

2. The plasma chamber (10, 20, 30) of claim 1, including a user interface for entering a desired voltage value, wherein the high-frequency voltage supply (11, 21, 31) is designed to generate the modulated high-frequency alternating voltage with an amplitude of a signal modulated thereon, which amplitude is predefined by the desired voltage value.

3. The plasma chamber (10, 20, 30) of claims 1 and 2, including a control unit, which is connected to the user interface of the high-frequency voltage supply (11,21,31) and to the measuring device and is designed to compare the measured value of the measuring device and the desired voltage value and to control the high-frequency voltage supply (11,21,31) according to a result of the comparison if the measured value of the measuring device differs from the voltage value entered via the user interface.

4. The plasma chamber (10, 20, 30) of any one of the preceding claims, in which the modulated high-frequency alternating voltage has a centre frequency and a bandwidth,
wherein the centre frequency is preferably between 50 kHz and 10 GHz,
wherein the bandwidth is preferably smaller than the centre frequency,
and wherein the bandwidth is preferably smaller than half the centre frequency.

5. The plasma chamber (10, 20, 30) of any one of the preceding claims, in which the modulated high-frequency alternating voltage includes at least one first sound of a first frequency and one second sound of a second frequency which differs from the first frequency by a difference frequency, which difference frequency is preferably at least 25 kHz and preferably not higher than 100 MHz.

6. The plasma chamber (10, 20, 30) of any one of the preceding claims, in which the modulated high-frequency alternating voltage is a multi-sound signal.

7. The plasma chamber (10, 20, 30) of any one of claims 1 to 5, in which the modulated high-frequency alternating voltage is an amplitude-modulated or a digitally modulated signal.

8. The plasma chamber (10, 20, 30) of any one of claims 1 to 5, in which the modulated high-frequency alternating voltage is a phase-modulated or frequency-modulated signal.

9. The plasma chamber (10, 20, 30) of any one of the preceding claims, in which a second holding device for a target (15, 25, 35) is arranged on a second side of the vacuum chamber (12, 22, 32).

10. The plasma chamber (10, 20, 30) of any one of the preceding claims, wherein the substrate (34) floats.

11. The plasma chamber (10, 20, 30) of any one of the preceding claims, wherein the inductive antenna is a waveguide antenna.

## Revendications

1. Chambre de plasma (10, 20, 30), comprenant un premier dispositif de réception pour un substrat (14, 24, 34) fixé sur un premier côté d'une chambre à vide (12, 22, 32), et une unité de génération de plasma destinée à générer un plasma dans la chambre de plasma (10, 20, 30), ladite unité de génération de plasma étant reliée à une alimentation en tension haute fréquence (11, 21, 31), ladite alimentation en tension haute fréquence (11,21,31) étant prévue pour générer une tension alternative haute fréquence modulée et à fournir celle-ci à l'unité de génération de plasma, et ladite unité de génération de plasma étant prévue pour générer le plasma avec la tension alternative haute fréquence modulée, ladite unité de génération de plasma étant une antenne inductive (36),
**caractérisée en ce que**
la chambre de plasma comporte un dispositif de mesure prévu pour déterminer un potentiel d'auto-polarisation du plasma dans la chambre de plasma et transmettre celui-ci sous forme de valeur de mesure, une cible étant disposée de manière flottante dans la chambre de plasma (10, 20, 30).

2. Chambre de plasma (10, 20, 30) selon la revendication 1, comprenant une interface d'utilisateur pour l'entrée d'une valeur de tension de consigne, l'alimentation en tension haute fréquence (11,21,31) étant prévue pour générer la tension alternative haute fréquence modulée avec une amplitude définie par la valeur de tension de consigne d'un signal modulé.

3. Chambre de plasma (10, 20, 30) selon les revendications 1 et 2, comprenant une unité de contrôle reliée à l'interface d'utilisateur, à l'alimentation en tension haute fréquence (11, 21, 31) et au dispositif de mesure et prévue pour comparer la valeur de mesure du dispositif de mesure et la valeur de tension de consigne, et pour réguler l'alimentation en tension haute fréquence (11,21,31) suivant un résultat de comparaison, si la valeur de mesure du dispositif de mesure diffère de la valeur de tension entrée par l'interface d'utilisateur.

4. Chambre de plasma (10, 20, 30) selon l'une des revendications précédentes, où la tension alternative haute fréquence modulée présente une fréquence centrale et une largeur de bande,
la fréquence centrale étant préférentiellement comprise entre 50 kHz et 10 GHz,
la largeur de bande étant préférentiellement inférieure à la fréquence centrale,
et la largeur de bande étant préférentiellement inférieure à la demi-fréquence centrale.

5. Chambre de plasma (10, 20, 30) selon l'une des revendications précédentes, où la tension alternative haute fréquence modulée est pourvue d'au moins une première tonalité à une première fréquence et d'une deuxième tonalité à une deuxième fréquence qui diffère de la première fréquence d'une fréquence différentielle, ladite fréquence différentielle étant préférentiellement d'au moins 25 kHz et préférentiellement de 100 MHz au plus.

6. Chambre de plasma (10, 20, 30) selon l'une des revendications précédentes, où la tension alternative haute fréquence modulée est un signal à tonalités multiples.

7. Chambre de plasma (10, 20, 30) selon l'une des revendications 1 à 5, où la tension alternative haute fréquence modulée est un signal modulé en amplitude ou modulé numériquement.

8. Chambre de plasma (10, 20, 30) selon l'une des revendications 1 à 5, où la tension alternative haute fréquence modulée est un signal modulé en phase ou en fréquence.

9. Chambre de plasma (10, 20, 30) selon l'une des revendications précédentes, où un deuxième dispositif de réception pour une cible (15, 25, 35) est situé sur un deuxième côté de la chambre à vide (12, 22, 32).

10. Chambre de plasma (10, 20, 30) selon l'une des revendications précédentes, où le substrat (34) est flottant.

11. Chambre de plasma (10, 20, 30) selon l'une des revendications précédentes, où l'antenne inductive est une antenne à guide d'onde.
